# EUROPEAN PATENT APPLICATION

(11) **EP 2 610 626 A1**
(43) Date of publication of application: **03.07.2013**
(21) Application number: 11819617.9
(22) Date of filing: 07.02.2011
(51) Int. Cl.: G01R 15/20

(54) **CURRENT DETECTOR**

(30) Priority: 23.08.2010 JP 2010185980
(71) Applicant: Sumitomo Wiring Systems, Ltd., Yokkaichi-shi, Mie 510-0058 (JP)
(72) Inventor: NAKAJIMA Hirokatsu, Yokkaichi-shi Mie 510-0058 (JP); CHAEN Satoru, Yokkaichi-shi Mie 510-0058 (JP)
(74) Representative: Winter, Brandl, Fürniss, Hübner, Röss, Kaiser, Polte - Partnerschaft
(86) International application number: PCT/JP2011/052517
(87) International publication number: WO 2012/026141

(57) **Abstract**

It is an object of the present invention to provide a current detector for detecting a current that flows through a busbar, in which it is possible to achieve both prevention of electronic components from being damaged by a high voltage flowing from the busbar, and reduction in the size of the current detector. A current detector (1) includes an electronic circuit board (50) on which a circuit for processing a detection signal of a Hall element (20) disposed in a gap portion (12) of a magnetic core (10) is mounted, and a spring member such as a coil spring (52) that is made of a conductor electrically connected to a ground pattern on the electronic circuit board (50), and that is supported on the electronic circuit board (50) and is in contact with the magnetic core (10). The magnetic core (10), a busbar (30) for current detection, and the electronic circuit board (50) on which the Hall element (20) has been mounted are held in a fixed positional relationship by an insulating casing (40).

## Description

### Technical Field

The present invention relates to a current detector for detecting a current that flows through a busbar.

### Background Art

Vehicles such as hybrid automobiles or electric automobiles in many cases include a current detector for detecting a current that flows through a busbar connected to a battery. Examples of apparatuses that may be applied as such a current detector include a magnetic proportion-type current detector and a magnetic balance-type current detector.

A current detector of a magnetic proportion type or a magnetic balance type includes a magnetic core and a magneto-electric conversion element (magnetic induction element), for example, as shown in Patent Document 1. The magnetic core is a magnetic material substantially in the shape of a ring with a gap portion, resulting in two ends facing each other across the gap portion, and formed in one piece so as to surround a hole portion through which a busbar penetrates. The hole portion of the magnetic material is a space (current detection space) through which a current that is to be detected flows.

Furthermore, the magneto-electric conversion element is disposed in the gap portion of the magnetic core. The magneto-electric conversion element is an element that detects changes in the magnetic flux of a current that flows through the busbar penetrating through the hole portion, and then outputs a detection signal of the magnetic flux as an electrical signal. As the magneto-electric conversion element, typically, a Hall element is used.

As shown in Patent Document 1, in conventional current detectors, the magnetic core, the busbar, and the magneto-electric conversion element are in many cases held in a fixed positional relationship by an insulating casing. A plurality of components forming the current detector are positioned in a fixed positional relationship by this casing.

When a high voltage is generated in the busbar due to a static electrical charge or the like, the high voltage may flow from the busbar and damage electronic components including the magneto-electric conversion element that is disposed close to the busbar and components that are electrically connected to the magneto-electric conversion element. In the current detector, the insulating casing provides isolation between the busbar and the magneto-electric conversion element, and also functions as an electrically shielding material that improves electrical insulation between the busbar and the electronic components including the magneto-electric conversion element. This function prevents the electronic components including the magneto-electric conversion element from being damaged by a high voltage flowing from the busbar.

### Citation List

### Patent Document

Patent Document 1: JP 2009-128116A

### Summary of Invention

### Technical Problem

Incidentally, recently, there is an increasing demand for reducing the size of current detectors that are fitted in vehicles. Accordingly, it is difficult to ensure a space for allowing an insulating member to electrically shield the magneto-electric conversion element from the busbar. That is to say, conventional current detectors are problematic in that it is difficult to achieve both prevention of electronic components from being damaged by a high voltage flowing from the busbar, and reduction in the size of the current detector.

It is an object of the present invention to provide a current detector for detecting a current that flows through a busbar, in which it is possible to achieve both prevention of electronic components from being damaged by a high voltage flowing from the busbar, and reduction in the size of the current detector.

### Solution to Problem

A current detector according to the present invention includes the following constituent components:
(1) a first constituent component is a magnetic core that has both of two ends thereof facing each other across a gap portion and that is formed in one piece so as to surround a hole portion through which a busbar allowing a current to flow therethrough penetrates;
(2) a second constituent component is a magneto-electric conversion element that is disposed in the gap portion and that detects changes in the magnetic flux of a current that flows through the hole portion;
(3) a third constituent component is an electronic circuit board on which a circuit for processing a detection signal of the magneto-electric conversion element is mounted; and
(4) a fourth constituent component is a spring member that is made of a conductor electrically connected to a ground pattern on the electronic circuit board, and that is supported on the electronic circuit board and is in contact with the magnetic core.

Furthermore, in the current detector according to the present invention, the busbar for current detection may further include the following constituent component:
(5) a fifth constituent component is a casing made of an insulating member that holds, in a fixed positional relationship, the magnetic core, the busbar, and the electronic circuit board on which the magneto-electric conversion element is mounted, in a state where the spring member elastically biases the magnetic core.

Furthermore, in the current detector according to the present invention, it is preferable that the spring member is a coil spring having one end fixed to the electronic circuit board.

Furthermore, in the current detector according to the present invention, it is preferable that the electronic circuit board and the casing have the following configuration if the spring member is a coil spring. That is to say, a through-hole in connection with an internal space of the coil spring is formed through the electronic circuit board. Furthermore, a protruding portion in a shape of a rod that penetrates through the through-hole of the electronic circuit board and extends into the internal space of the coil spring is formed on the casing.

### Advantageous effects of Invention

In the current detector according to the present invention, the magnetic core that is disposed closest to the busbar for current detection is electrically connected via the spring member to the ground pattern. Furthermore, typically, the ground pattern on the electronic circuit board is electrically connected to a ground conductor such as a vehicle body, via an electrical wire connected via the connector and the like. Accordingly, when a high voltage is generated in the busbar due to a static electrical charge or the like, the high-voltage electricity flows from the busbar via the magnetic core, the spring member, and the ground pattern on the electronic circuit board to the ground conductor such as the vehicle body. Furthermore, typically, a surge suppression circuit such as a surge absorber is mounted on the electronic circuit board in order to suppress surges between the electronic components and the ground pattern.

Thus, according to the present invention, it is possible to prevent electronic components from being damaged by a high voltage flowing from the busbar. Furthermore, according to the present invention, since there is no need to ensure a large space for allowing an insulating member to electrically shield the magneto-electric conversion element from the busbar, it is possible to reduce the size of the current detector.

Incidentally, conceivable examples of a mode for electrically connecting the magnetic core and the ground conductor such as a vehicle body also include a first connection mode and a second connection mode described below. That is to say, the first connection mode is a mode in which the magnetic core and the ground pattern on the electronic circuit board are in direct contact with each other. The second connection mode is a mode in which an electrical wire electrically connected to the ground conductor is connected to the magnetic core by welding, screwing, or the like. However, the first connection mode is problematic in that the contact state between the magnetic core and the ground pattern on the electronic circuit board is not stable depending on dimensional tolerance. Furthermore, the second connection mode is problematic in that the thermal load or physical load that acts on the magnetic core is large, and this load adversely affects the current detection performance.

Meanwhile, according to the present invention, since the spring member that electrically connects the magnetic core and the ground pattern on the electronic circuit board is elastically deflected, the electrical contact state between the magnetic core and the ground pattern on the electronic circuit board is stable, and the physical load that acts on the magnetic core can be made small.

Furthermore, according to the current detector according to the present invention, since the magnetic core, the busbar, and the electronic circuit board on which the magneto-electric conversion element has been mounted are held in a fixed positional relationship by the casing, the current detector can be easily attached to other pre-installed busbars.

Furthermore, when the spring member is a coil spring having one end fixed to the electronic circuit board, the force of the spring member that elastically biases the magnetic core is more stable than when another type of spring member such as a leaf spring is used, and, thus, the electrical connection state between the magnetic core and the ground pattern on the electronic circuit board tends to be more stable.

Furthermore, in the present invention, when a protruding portion in a shape of a rod that penetrates through the through-hole of the electronic circuit board and extends into the internal space of the coil spring is formed on the casing, the protruding portion keeps the coil spring from being deflected (bent) in the width direction orthogonal to the axial direction, thereby making the coil spring compressible and stretchable mainly only in the axial direction. As a result, a failure in contact with the magnetic core due to excessive deflection of the coil spring in the width direction is prevented from occurring.

### Brief Description of Drawings

FIG. 1 shows an exploded perspective view of a current detector 1 according to an embodiment of the present invention.
FIG. 2 shows views of three sides of a busbar 30 for current detection included in the current detector 1.
FIG. 3 shows a plan view of a component for forming the busbar 30 for current detection.
FIG. 4 shows a plan view of the current detector 1.
FIG. 5 shows a cross-sectional view of the current detector 1.
FIG. 6 shows a schematic perspective view of a state in which the current detector 1 is joined with pre-installed busbars.

### Description of Embodiment

Hereinafter, an embodiment of the present invention will be described with reference to the appended drawings. The following embodiment is merely a specific example of the invention, and is not to restrict the technical scope of the invention.

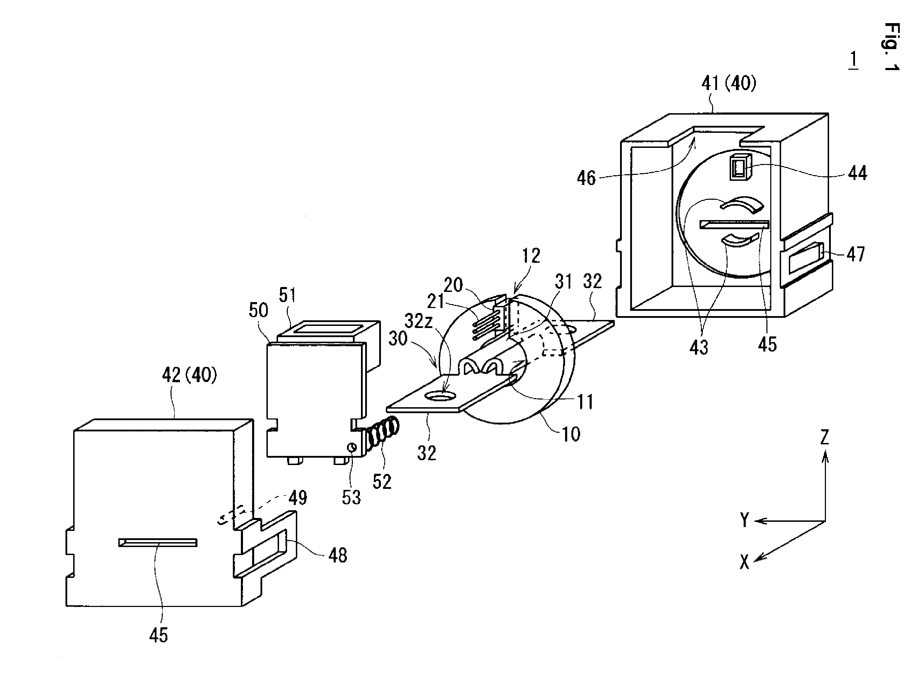

First, the configuration of a current detector 1 according to an embodiment of the present invention will be described with reference to FIGS. 1 to 5. The current detector 1 is an apparatus for detecting a current that flows through a busbar electrically connecting a battery and a device such as a motor, in vehicles such as hybrid automobiles or electric automobiles. As shown in FIG. 1, the current detector 1 includes a magnetic core 10, a Hall element 20, a busbar 30 for current detection, an insulating casing 40, an electronic circuit board 50, and a coil spring 52 that is supported on the electronic circuit board 50.

### <Magnetic core>

The magnetic core 10 is a magnetic material made of ferrite, silicon steel, or the like, and is in a shape that has both of its two ends facing each other across a gap portion 12 with a size of approximately several millimeters, and that is formed in one piece so as to surround a hole portion 11. That is to say, the magnetic core 10 is substantially in the shape of a continuous loop except that it has the narrow gap portion 12. The magnetic core 10 in this embodiment is substantially in the shape of a ring that surrounds the circular hole portion 11.

### <Hall element (magneto-electric conversion element)>

The Hall element 20 is disposed in the gap portion 12 of the magnetic core 10. The Hall element 20 is an example of a magneto-electric conversion element for detecting changes in the magnetic flux of a current that flows through the hole portion 11 of the magnetic core 10, and then outputting a detection signal of the magnetic flux as an electrical signal.

### <Electronic circuit board>

The electronic circuit board 50 is a printed circuit board on which a terminal 21 of the Hall element 20 is mounted. In addition to the Hall element 20, a circuit that amplifies the detection signal of the magnetic flux output from the Hall element 20, and a connector 51 that connects this circuit and another external circuit are mounted on the electronic circuit board 50. Accordingly, the connector 51 is electrically connected to the Hall element 20, and the Hall element 20 is connected, via the electronic circuit board 50 including the connector 51, to the external circuit. Furthermore, the connector 51 includes a ground terminal that is electrically connected to a ground pattern on the electronic circuit board 50. The ground pattern on the electronic circuit board 50 is electrically connected to a ground conductor such as a vehicle body, via the ground terminal of the connector 51 and a grounding electrical wire that is connected to this ground terminal.

Furthermore, a surge suppression circuit is mounted on the electronic circuit board 50. The surge suppression circuit is an element or a circuit such as a surge absorber or an RC circuit mounted in order to suppress surges between the Hall element 20 and other electronic components that are mounted on the electronic circuit board 50 and the ground pattern that is printed on the electronic circuit board 50. The surge suppression circuit blocks propagation of a noise voltage to electronic components that are mounted on the electronic circuit board 50, when a noise voltage such as pulse-like high voltage is generated on the ground pattern on the electronic circuit board 50.

### <Coil spring>

The coil spring 52 is a member made of a conductor such as copper, aluminum, or stainless steel in the shape of a coil electrically connected to the ground pattern on the electronic circuit board 50. The coil spring 52 is elastically compressed, and has one end fixed to the electronic circuit board 50 and the other end in contact with the magnetic core 10. For example, one end of the coil spring 52 is soldered to the ground pattern on the electronic circuit board 50 or is fitted to metal fittings mounted on the ground pattern on the electronic circuit board 50, and, thus, the coil spring 52 is fixed to the electronic circuit board 50.

Furthermore, in a portion of the electronic circuit board 50 to which the coil spring 52 is fixed, a through-hole 53 for the spring is formed in connection with the internal space of the coil spring 52. The role of the through-hole 53 for the spring will be described later.

### <Busbar for current detection>

The busbar 30 for current detection is a conductor made of a metal such as copper, and functions as part of a set of busbars electrically connecting a battery and an electrical device. That is to say, a current that is to be detected flows through the busbar 30 for current detection. Furthermore, the busbar 30 for current detection is a member independent of a battery-side busbar that is connected in advance with the battery and a device-side busbar that is connected in advance with the electrical device. Both ends of the busbar 30 for current detection are respectively connected to the other pre-installed busbars (the battery-side busbar and the device-side busbar).

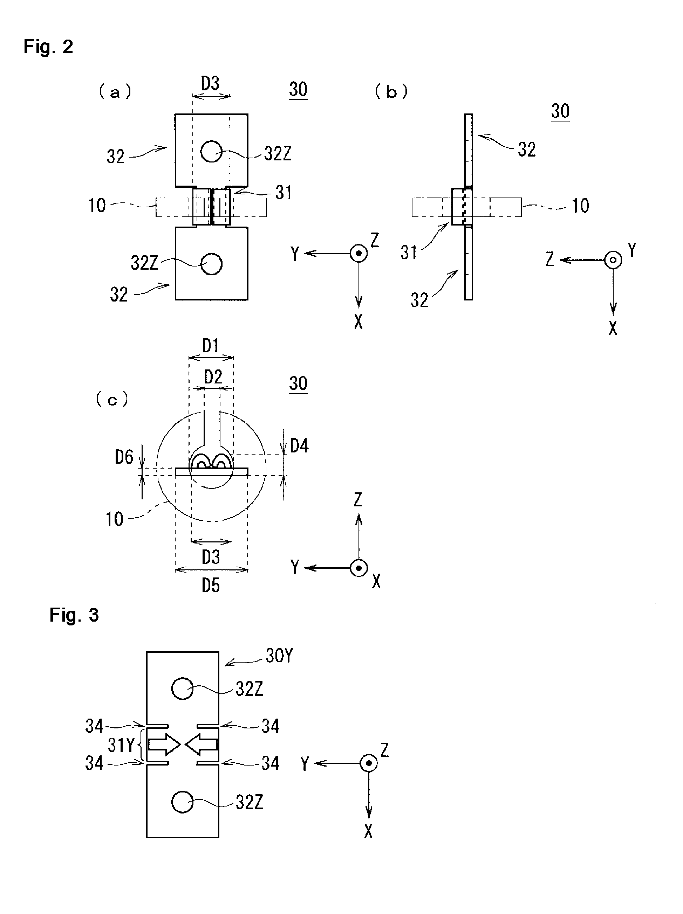

FIG. 2 shows views of three sides of the busbar 30 for current detection, wherein FIG. 2(a) is a plan view, FIG. 2(b) is a side view, and FIG. 2(c) is a front view. Furthermore, in FIG. 2, the magnetic core 10 that is combined with the busbar 30 for current detection is indicated by a broken line (double-dashed line).

As shown in FIGS. 1 and 2, the busbar 30 for current detection is substantially configured by a first portion 31 that occupies a constant range at the center and second portions 32 that are located at both sides of the first portion 31. The first portion 31 is a portion that penetrates through the hole portion 11 of the magnetic core 10 in the current flow direction. The current flow direction is the thickness direction of the magnetic core 10, is the axial direction of a cylinder when assuming the ring-like magnetic core 10 as a cylinder, and is the direction orthogonal to a plane formed by the ring-like magnetic core 10. In the drawings, the current flow direction is indicated as the X-axis direction. In the following description, the current flow direction (the X-axis direction) is referred to as a first direction.

The busbar 30 for current detection is a member made of a conductor including the first portion 31 that penetrates through the hole portion 11 of the magnetic core 10 in the first direction and the second portions 32 that are in the shape of flat plates which are in connection with the first portion 31 on both sides in the first direction. In the drawings, the width direction and the thickness direction of the flat plate-like second portions 32 are respectively indicated as the Y-axis direction and the Z-axis direction. In the following description, the width direction (the Y-axis direction) and the thickness direction (the Z-axis direction) of the flat plate-like second portions 32 are respectively indicated as a second direction and a third direction.

As shown in FIG. 3, the busbar 30 for current detection is a member having a structure in which one portion 31Y of a flat plate-like metal member 30Y is folded back from both sides in the second direction (the Y-axis direction) along slits 34 that are formed on both sides of the portion 31Y in the first direction (the X-axis direction). The slits 34 in the metal member 30Y are formed on both sides of the portion 31Y in the first direction (the X-axis direction) so as to extend from both ends in the second direction (the Y-axis direction) to the inner side. The folded-back portion 31Y forms the first portion 31 of the busbar 30 for current detection, and portions on both sides of the folded-back portion 31Y form the second portions 32. Such a busbar 30 for current detection can be easily manufactured.

In the busbar 30 for current detection, the contour shape of a cross-section of the first portion 31 is narrower than that of the second portions 32 in the second direction (the Y-axis direction). As a result, when this busbar 30 for current detection is used in the current detector 1, a relatively small magnetic core 10 can be used based on the relationship with the width of the busbar, and, thus, the size of the entire current detector including the magnetic core 10 can be kept small.

Furthermore, in the busbar 30 for current detection, the contour shape of a cross-section of the first portion 31 is such that a smallest width D4 is larger than a thickness (smallest width) D6 of the second portions 32. Accordingly, the conductor cross-sectional area at the first portion 31 is not significantly smaller than the conductor cross-sectional area at the second portions 32. In particular, in the case of the busbar 30 for current detection having a structure in which the flat plate-like metal member 30Y is partially folded back, the conductor cross-sectional area at the first portion 31 is equal to the conductor cross-sectional area at the second portions 32.

Note that portions of the busbar 30 for current detection where the slits 34 are formed between the first portion 31 and the second portions 32 each have a conductor cross-sectional area smaller than that of a portion located in front of or behind that portion. However, experiments found that, if the width of the slits 34 is very narrow, an increase in the impedance at the portions where the slits 34 are formed is a small value that is almost negligible in the entire busbar 30 for current detection. Accordingly, if the slits 34 formed in the busbar 30 for current detection each have a very narrow width, heat can be prevented from being excessively generated at the first portion 31.

Furthermore, the second portions 32 of the busbar 30 for current detection respectively have screw holes 32Z into which screws for joining this busbar with other busbars are inserted. The second portions 32 in which the holes 32Z are formed function as terminal portions that are joined with other busbars.

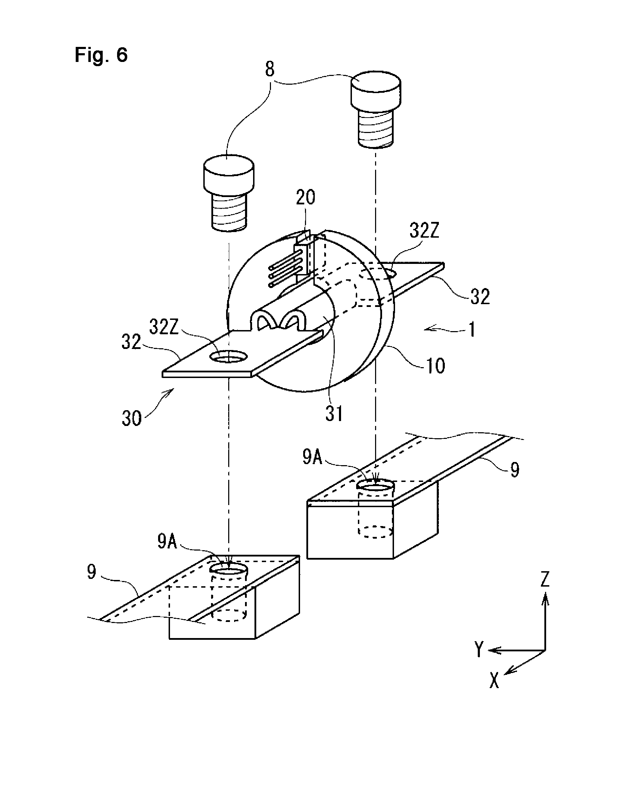

FIG. 6 is a perspective view schematically showing a state in which the second portions (the terminal portions) 32 of the busbar 30 for current detection in the current detector 1 are joined with other pre-installed busbars 9 via screws 8. Note that, in FIG. 6, the insulating casing 40 is not shown for the sake of convenience. As shown in FIG. 6, portions of the other busbars 9 that are joined with the second portions 32 of the busbar 30 for current detection are configured, for example, as terminal blocks, and have screw holes 9A. Note that the terminal portions formed in the second portions 32 may be other than the screw holes 32Z, such as portions having fitting mechanisms to the other busbars 9.

### <Insulating casing>

The insulating casing 40 is an insulating member that holds, in a fixed positional relationship, the magnetic core 10, the busbar 30 for current detection, and the electronic circuit board 50 on which the Hall element 20 has been mounted. The insulating casing 40 includes a casing main body 41 and a cover member 42 that is attached to the casing main body 41. The casing main body 41 and the cover member 42 are, for example, each a monolithic molded member made of insulating resin such as polyamide (PA), polypropylene (PP), or ABS resin.

The casing main body 41 is in the shape of a box having an opening portion, and the cover member 42 covers the opening portion of the casing main body 41 when attached to the casing main body 41. The internal face of the casing main body 41 has first holding portions 43 and a second holding portion 44 that project out from the surface. On the casing main body 41, the first holding portions 43 and the second holding portion 44 hold the magnetic core 10, the busbar 30 for current detection that penetrates through the hole portion 11, and the Hall element 20 that is disposed in the gap portion 12, while keeping them from coming into contact with each other.

More specifically, the first holding portions 43 are fitted into a gap between the magnetic core 10 and the first portion 31 of the busbar 30 for current detection that penetrates through the hole portion 11 of the magnetic core 10, thereby holding the magnetic core 10 and the busbar 30 for current detection while keeping them from coming into contact with each other. Furthermore, the second holding portion 44 is fitted into a gap between the magnetic core 10 and the Hall element 20 that is disposed in the gap portion 12 of the magnetic core 10, thereby holding the magnetic core 10 and the Hall element 20 while keeping them from coming into contact with each other.

Furthermore, the casing main body 41 and the cover member 42 respectively have slots 45 through which the second portions 32 at both ends of the busbar 30 for current detection are inserted from the inner side to the outer sides. In a state where one of the second portions 32 in the busbar 30 for current detection that penetrates through the hole portion 11 of the magnetic core 10 has been inserted through the slot 45 of the casing main body 41, the first holding portions 43 and the second holding portion 44 of the casing main body 41 hold, in a fixed positional relationship, the magnetic core 10, the Hall element 20, and the busbar 30 for current detection while keeping them from coming into contact with each other.

Furthermore, the cover member 42 is attached to the casing main body 41 holding the magnetic core 10, the Hall element 20, and the busbar 30 for current detection such that the cover member 42 covers the opening portion of the casing main body 41 while sandwiching the electronic circuit board 50 therebetween. At that time, the other second portion 32 in the busbar 30 for current detection is inserted through the slot 45 of the cover member 42 from the inner side to the outer side, and, thus, the electronic circuit board 50 is sandwiched between the casing main body 41 and the cover member 42.

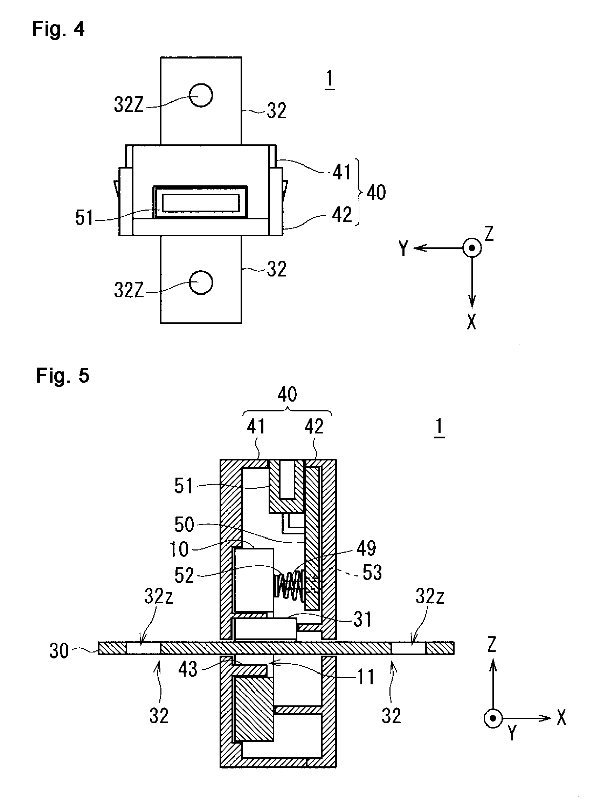

FIGS. 4 and 5 are a plan view and a cross-sectional view of the current detector 1 in which the casing main body 41 and the cover member 42 have been combined with each other. Note that, in FIG. 5, the Hall element 20 is not shown for the sake of convenience.

As shown in FIGS. 4 and 5, when the electronic circuit board 50 is sandwiched between the casing main body 41 and the cover member 42, the connector 51 mounted on the electronic circuit board 50 is held in a state where it is fitted to a cut-out portion 46 that is formed in the casing main body 41. Furthermore, the casing main body 41 and the cover member 42 sandwich the magnetic core 10 and the electronic circuit board 50 therebetween in a state where the free end of the coil spring 52 that has been fixed to the electronic circuit board 50 elastically biases the magnetic core 10.

Furthermore, the casing main body 41 and the cover member 42 are provided with lock mechanisms 47 and 48 that hold the casing main body 41 and the cover member 42 such that they are combined with each other. The lock mechanisms 47 and 48 shown in FIG. 1 are respectively configured as a catch portion 47 that is formed so as to project from a side face of the casing main body 41 and a frame portion 48 that is in the shape of a loop on a side face of the cover member 42. When the catch portion 47 of the casing main body 41 is fitted to the hole defined by the frame portion 48 of the cover member 42, the casing main body 41 and the cover member 42 are held in a state where they are combined with each other. In this manner, the insulating casing 40 holds, in a fixed positional relationship, the magnetic core 10, the busbar 30 for current detection, and the electronic circuit board 50 on which the Hall element 20 has been mounted, in a state where the coil spring 52 elastically biases the magnetic core 10. In the current detector 1, a conductor that is disposed closest to the busbar 30 for current detection is the magnetic core 10.

Furthermore, as shown in FIGS. 1 and 5, the internal face of the cover member 42 forming the insulating casing 40 has a protruding portion 49 in the shape of a rod that penetrates through the through-hole 53 for the spring of the electronic circuit board 50 and extends into the internal space of the coil spring 52. The protruding portion 49 keeps the coil spring 52 from being deflected (bent) in the width direction orthogonal to the axial direction, thereby making the coil spring 52 compressible and stretchable mainly only in the axial direction. As a result, a failure in contact with the magnetic core 10 due to excessive deflection of the coil spring 52 in the width direction is prevented from occurring.

Note that, in FIGS. 1 and 5, the axial direction of the coil spring 52 matches the X-axis direction. Furthermore, the internal face of the cover member 42 has, in addition to the rod-like protruding portion 49, other protruding portions for positioning components that are accommodated in the insulating casing 40, but the protruding portions other than the rod-like protruding portion 49 are not shown in FIG. 1.

Furthermore, as shown in FIG. 4, the casing main body 41 and the cover member 42 (the insulating casing 40) cover and hold the magnetic core 10, the first portion 31 of the busbar 30 for current detection, and the Hall element 20 in a state where the portions (terminal portions) of the second portions 32 of the busbar 30 for current detection in which the holes 32Z are formed and the connector 51 of the electronic circuit board 50 are exposed to the outside.

In the current detector 1 described above, the magnetic core 10 that is disposed closest to the busbar 30 for current detection is electrically connected via the coil spring 52 to the ground pattern on the electronic circuit board 50. Furthermore, the ground pattern on the electronic circuit board 50 is electrically connected to a ground conductor such as a vehicle body, via the grounding electrical wire connected via the connector 51. Accordingly, when a high voltage is generated in the busbar 30 for current detection due to a static electrical charge or the like, the high-voltage electricity flows from the busbar 30 for current detection via the magnetic core 10, the coil spring 52, and the ground pattern on the electronic circuit board 50 to the ground conductor. A surge suppression circuit is mounted on the electronic circuit board 50 in order to suppress surges between the electronic components including the Hall element 20 and the ground pattern.

Accordingly, use of the current detector 1 can prevent electronic components from being damaged by a high voltage flowing from the busbar 30 for current detection. Furthermore, according to the current detector 1, since there is no need to ensure a large space for allowing an insulating member to electrically shield the electronic components including the Hall element 20 from the busbar 30 for current detection, it is possible to reduce the size of the current detector.

Furthermore, according to the current detector 1, since the coil spring 52 that electrically connects the magnetic core 10 and the ground pattern on the electronic circuit board 50 is elastically deflected, the electrical contact state between the magnetic core 10 and the ground pattern on the electronic circuit board 50 is stable, and the physical load that acts on the magnetic core 10 can be made small. Moreover, since the coil spring 52 presses with its elastic force the magnetic core 10 and the electronic circuit board 50 against the insulating casing 40, the magnetic core 10 and the electronic circuit board 50 held by the insulating casing 40 are prevented from wobbling.

In particular, when the coil spring 52 is used, the force of the spring member that elastically biases the magnetic core 10 is more stable than when another type of spring member such as a leaf spring is used, and, thus, the electrical connection state between the magnetic core 10 and the ground pattern on the electronic circuit board 50 tends to be more stable. It will be appreciated that other spring members such as a leaf spring connected to the ground pattern on the electronic circuit board 50 may be used instead of the coil spring 52.

Furthermore, the current detector 1 in which the magnetic core 10, the busbar 30 for current detection, the Hall element 20, and the electronic circuit board 50 are held in a fixed positional relationship by the insulating casing 40 can be easily attached to pre-installed busbars that are located in front of and behind the current detector 1.

**List of Reference Numerals**

| | |
|---|---|
| 1 | Current detector |
| 8 | Screw |
| 9 | Another busbar |
| 10 | Magnetic core |
| 11 | Hole portion |
| 12 | Gap portion |
| 20 | Hall element |
| 21 | Terminal |
| 30 | Busbar for current detection |
| 30Y | Metal member |
| 31 | First portion |
| 32 | Second portion (terminal portion) |
| 32Z | Hole |
| 34 | Slit |
| 40 | Insulating casing |
| 41 | Casing main body |
| 42 | Cover member |
| 43 | First holding portion |
| 44 | Second holding portion |
| 45 | Slot |
| 47 | Catch portion (lock mechanism) |
| 48 | Frame portion (lock mechanism) |
| 49 | Protruding portion |
| 50 | Electronic circuit board |
| 51 | Connector |
| 52 | Coil spring (spring member) |
| 53 | Through-hole for spring |

## Claims

1. A current detector (1) provided with a magnetic core (10) that has both of two ends thereof facing each other across a gap portion (12) and that is formed in one piece so as to surround a hole portion (11) through which a busbar (30) allowing a current to flow therethrough penetrates, and a magneto-electric conversion element (20) that is disposed in the gap portion (12) and that detects changes in the magnetic flux of a current that flows through the hole portion (11), comprising:
an electronic circuit board (50) on which a circuit for processing a detection signal of the magneto-electric conversion element (20) is mounted; and
a spring member (52) that is made of a conductor electrically connected to a ground pattern on the electronic circuit board (50), and that is supported on the electronic circuit board (50) and is in contact with the magnetic core (10).

2. The current detector (1) according to claim 1, further comprising a casing (40) made of an insulating member that holds, in a fixed positional relationship, the magnetic core (10), the busbar (30), and the electronic circuit board (50) on which the magneto-electric conversion element (20) is mounted, in a state where the spring member (52) elastically biases the magnetic core (10).

3. The current detector according to claim 2, wherein the spring member is a coil spring (52) having one end fixed to the electronic circuit board (50).

4. The current detector according to claim 3,
wherein a through-hole (53) in connection with an internal space of the coil spring (52) is formed through the electronic circuit board (50), and
a protruding portion (49) in a shape of a rod that penetrates through the through-hole (53) of the electronic circuit board (50) and extends into the internal space of the coil spring (52) is formed on the casing (40).
